# EUROPEAN PATENT APPLICATION

(11) **EP 3 330 820 A1**
(43) Date of publication of application: **06.06.2018**
(21) Application number: 17202989.4
(22) Date of filing: 22.11.2017
(51) Int. Cl.: G05B 23/02

(54) **CALCULATION METHOD FOR COMPRESSED AIR-FLOW RATE, CALCULATION DEVICE THEREOF, AND STORAGE MEDIUM**

(30) Priority: 30.11.2016 JP 2016232980
(71) Applicant: TOYOTA JIDOSHA KABUSHIKI KAISHA, Toyota-shi, Aichi-ken, 471-8571 (JP)
(72) Inventor: KITAGAWA, Hirokazu, Toyota-shi, Aich-ken 471-8571 (JP)
(74) Representative: Cabinet Beau de Loménie

(57) **Abstract**

A compressed air-flow rate calculation method of the present invention includes storing, in a storage device, time series data of a compressed air-flow rate used in each of plurality of production facilities during an operation period, and performing simulation. Simulation includes generating, for each of the plurality of production facilities, time series data on the compressed air-flow rate in each of the production facilities during a prescribed period by acquiring from the storage device the time series data on the compressed air-flow rate in each of the production facilities during the operation period, whenever operation start timing is determined to have come in each of the production facilities. Time series data on the total compressed air-flow rate in the entire production line during the prescribed period is calculated by integrating the time series data on the compressed air-flow rate in each of plurality of production facilities during the prescribed period.

## Description

### BACKGROUND OF THE INVENTION

### 1. Field of the Invention

The present invention relates to a compressed air-flow rate calculation method for calculating a total compressed air-flow rate used in an entire production line having a plurality of production facilities that use compressed air. The present invention also relates to a calculation device thereof, and a storage medium.

### 2. Description of Related Art

In a production line, compressed air may be used in a plurality of production facilities. However, the plurality of production facilities are each different in operational status, which makes it difficult to calculate an accurate total compressed air-flow rate used in the entire production line.

When a compressor that generates a large amount of compressed air is selected as a compressor for such a production line, the compressor' performance is often excessive for an actual total compressed air-flow rate. This causes such disadvantages as an increased investment cost due to increased purchase expense of the compressor, an increased running cost due to increased electrical charges, and failed energy saving due to deteriorated energy efficiency.

Accordingly, it is preferable to select a compressor having a small output volume in terms of the investment, the running cost, and the energy saving. However, when the compressor having a small output volume is selected, it is necessary to adjust the total compressed air-flow rate used in the entire production line to be less than the compressed air output volume generated by the compressor.

For example, Japanese Patent Application Publication No. 2010-128625 discloses a technique that simulates, in a factory having a plurality of production facilities that use compressed air, time series variation of a total compressed air-flow rate based on time series data on the compressed air-flow rate in each of the production facilities and tact time, and adjusts operation start and operation stop timing of any one of the production facilities based on the simulation result so as to prevent the total compressed air-flow rate from becoming a threshold or more.

### SUMMARY OF THE INVENTION

As described above, the technique disclosed in JP 2010-128625 A adjusts the operation start and operation stop timing of any one of the production facilities so as to prevent the total compressed air-flow rate from becoming the threshold or more. However, when the operation start and operation stop timing of any one of the production facilities is arbitrarily changed in the production line having a plurality of production facilities which are different in the timing of starting and stopping the operation, a problem that finished products cannot be produced as scheduled arises.

One of the solutions to the problem is to accurately calculate the total compressed air-flow rate used in the entire production line having a plurality of production facilities that use compressed air, even in the case where the plurality of production facilities are each different in the operation start and operation stop timing. That is, when the total compressed air-flow rate used in the entire production line can accurately be calculated in such a situation as described above, it becomes possible to select a compressor of a proper output volume. When the compressor of the proper output volume can be selected, it becomes possible to eliminate the necessity of adjusting the operation start and operation stop timing of any one of the production facilities as disclosed in JP 2010-128625 A. As a result, finished products can be produced as scheduled. Furthermore, when the compressor of the proper output volume can be selected, the compressor having excessive performance can be avoided, which is advantageous in terms of the investment, the running cost, and the energy saving.

The present invention provides a technique for a production line having a plurality of production facilities that use compressed air, the technique achieving accurate calculation of a total compressed air-flow rate used in the entire production line even in the case where the plurality of production facilities are each different in operation start and operation stop timing.

One aspect of the present invention relates to a compressed air-flow rate calculation method. The one aspect of the present invention is a compressed air-flow rate calculation method for calculating a total compressed air-flow rate used in an entire production line having a plurality of production facilities that use compressed air, the method including: inputting facility information including the number of the plurality of production facilities and layout information, and production supplementary information including information on tact time of the entire production line; storing, in a storage device, time series data representative of time series variation of a compressed air-flow rate for each of the plurality of production facilities, the compressed air-flow rate being used in each of the production facilities during an operation period from an operation start to an operation stop; and simulating time series variation of the total compressed air-flow rate used in the entire production line during a prescribed period, wherein the simulation includes determining, for each of the plurality of production facilities, whether or not operation start timing has come in each of the production facilities during the prescribed period, generating, for each of the plurality of production facilities, time series data on the compressed air-flow rate used in each of the production facilities during the prescribed period by acquiring, from the storage device, the time series data on the compressed air-flow rate used in each of the production facilities during the operation period, whenever the operation start timing is determined to have come in each of the production facilities, and calculating time series data representative of the time series variation of the total compressed air-flow rate used in the entire production line during the prescribed period by integrating the time series data on the compressed air-flow rate used during the prescribed period, the time series data being generated for each of the plurality of production facilities.

In the one aspect of the present invention, a waveform that is digitized time series data on the compressed air-flow rate used in each of the plurality of production facilities during the operation period may be stored in the storage device for each of the production facilities.

In the one aspect of the present invention, in the case where a process executed by one of the production facilities is a first process, and no workpiece is present in the production facility, the operation start timing may be determined to have come in the production facility when the workpiece is brought into the production facility, whereas in the case where the process executed by one of the production facilities is not the first process, no workpiece is present in the production facility, and a workpiece is present in a production facility that executes a process previous to the process executed by the one of the production facilities, the operation start timing may be determined to have come in the one of the production facilities when the workpiece is brought into the one of the production facilities.

A second aspect of the present invention relates to a compressed air-flow rate calculation device. The second aspect of the present invention is a compressed air-flow rate calculation device for calculating a total compressed air-flow rate used in an entire production line having a plurality of production facilities that use compressed air, the calculation device including: an input device configured to receive input of facility information including the number of the plurality of production facilities and layout information thereon, and production supplementary information including information on tact time of the entire production line; a storage device configured to store time series data representative of time series variation of a compressed air-flow rate for each of the plurality of production facilities, the compressed air-flow rate being used in each of the production facilities during an operation period from an operation start to an operation stop; and a processor configured to simulate time series variation of the total compressed air-flow rate used in the entire production line during a prescribed period, wherein the processor is configured to determine, for each of the plurality of production facilities, whether or not operation start timing has come in each of the production facilities during the prescribed period that is during the simulation, generate, for each of the plurality of production facilities, time series data on the compressed air-flow rate used in each of the production facilities during the prescribed period by acquiring, from the storage device, the time series data on the compressed air-flow rate used in each of the production facilities during the operation period, whenever the operation start timing is determined to have come in each of the production facilities, and calculate time series data representative of the time series variation of the total compressed air-flow rate used in the entire production line during the prescribed period by integrating the time series data on the compressed air-flow rate used during the prescribed period, the time series data being generated for each of the plurality of production facilities.

A third aspect of the present invention relates to a computer-readable storage medium. The third aspect is configured to store a computer program and cause a computer to execute steps upon execution of the computer program, the steps including: input steps of inputting, in the computer configured to calculate a total compressed air-flow rate used in an entire production line having a plurality of production facilities that use compressed air, facility information including the number of the plurality of production facilities and layout information, and production supplementary information including information on tact time of the entire production line; a storage step of storing, in a storage device, time series data representative of time series variation of a compressed air-flow rate for each of the plurality of production facilities, the compressed air-flow rate being used in each of the production facilities during an operation period from an operation start to an operation stop; and a simulation step of simulating time series variation of the total compressed air-flow rate used in the entire production line during a prescribed period, wherein the simulation step includes a determination step of determining, for each of the plurality of production facilities, whether or not operation start timing has come in each of the production facilities during the prescribed period, a generation step of generating, for each of the plurality of production facilities, time series data on the compressed air-flow rate used in each of the production facilities during the prescribed period by acquiring, from the storage device, the time series data on the compressed air-flow rate used in each of the production facilities during the operation period, whenever the operation start timing is determined to have come in each of the production facilities, and a calculation step of calculating time series data representative of the time series variation of the total compressed air-flow rate used in the entire production line during the prescribed period by integrating the time series data on the compressed air-flow rate used during the prescribed period, the time series data being generated for each of the plurality of production facilities.

The above-stated aspects of the present invention can effectively implement, in the production line having a plurality of production facilities that use compressed air, accurate calculation of a total compressed air-flow rate used in the entire production line even in the case where the plurality of production facilities are each different in operation start and operation stop timing.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 illustrates one example of a hardware configuration of a computer that implements a calculation device for a compressed air-flow rate according to an embodiment;
FIG. 2 is a flowchart illustrating one example of pre-processing performed before simulation in a compressed air-flow rate calculation method according to an embodiment;
FIG. 3 illustrates one example of an input screen displayed in steps S101, S102 of FIG. 2;
FIG. 4 illustrates one example of an input screen displayed in step S103 of FIG. 2;
FIG. 5 illustrates one example of an input screen displayed in step S103 of FIG. 2;
FIG. 6 illustrates one example of processing for digitizing special waveforms in step S106 of FIG. 2;
FIG. 7 illustrates one example of an input screen displayed in step S108 of FIG. 2;
FIG. 8 illustrates one example of an input screen displayed in steps S109, S110 of FIG. 2;
FIG. 9 illustrates one example of a layout of a plurality of production facilities included in a production line;
FIG. 10A is a flowchart illustrating one example of simulation processing in the compressed air-flow rate calculation method according to the embodiment;
FIG. 10B is a flowchart illustrating one example of simulation processing in the compressed air-flow rate calculation method according to the embodiment;
FIG. 11 illustrates one example of actual measurements of time series data on a total compressed air-flow rate in the entire production line when the production line has a conveyor;
FIG. 12 illustrates one example of actual measurements of the time series data on the total compressed air-flow rate in the entire production line when the production line has no conveyor;
FIG. 13A illustrates a specific example of a digitized waveform of the time series data on the compressed air-flow rate in a production facility A during an operation period;
FIG. 13B illustrates a specific example of a digitized waveform of the time series data on the compressed air-flow rate in a production facility B during the operation period;
FIG. 13C illustrates a specific example of a digitized waveform of the time series data on the compressed air-flow rate in a production facility C during the operation period; and
FIG. 14 illustrates a specific example of a calculation result of the time series data on the total compressed air-flow rate in the entire production line during simulation time.

### DETAILED DESCRIPTION OF EMBODIMENTS

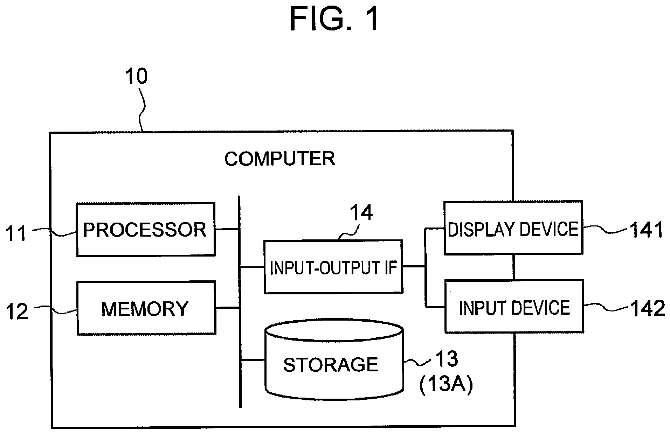

Embodiments of the present invention will be described below with reference to the drawings. First, a configuration example of a computer 10, which implements the compressed air-flow rate calculation device according to the present embodiment will be described with reference to FIG. 1. As illustrated in FIG. 1, the computer 10 includes a processor 11, a memory 12, a storage 13, and an input-output interface (input-output IF) 14. The processor 11, the memory 12, the storage 13, and the input-output interface 14 are connected through a transmission line for exchanging data with each other.

For example, the processor 11 is an arithmetic processor such as a central processing unit (CPU). For example, the memory 12 is such a memory as a random access memory (RAM) and a read only memory (ROM). For example, the storage 13 is a storage device such as a hard disk drive (HDD), a solid state drive (SSD), and a memory card.

The storage 13 stores a program for causing the computer 10 to execute the calculation method for the compressed air-flow rate according to the present embodiment, i.e., a method for calculating a total compressed air-flow rate used in the entire production line having a plurality of production facilities that use compressed air. The processor 11 reads the aforementioned program from the storage 13, and executes the read program to implement the compressed air-flow rate calculation method according to the present embodiment. Here, when executing the aforementioned program, the processor 11 may read the aforementioned program on the memory 12 and then execute the read program, or may execute the program without reading it on the memory 12. The program may be stored in various types of non-transitory computer-readable media, and be supplied to the computer. The non-transitory computer-readable media include various types of tangible storage media. Examples of the non-transitory computer-readable media include magnetic storage media (for example, a flexible disk, a magnetic tape, and a hard disk drive), optical magnetic storage media (for example, a magneto-optical disk), compact disc read-only memories (CD-ROMs), CD-Rs, CD-RWs, semiconductor memories (for example, a mask ROM, a programmable ROM (PROM), an erasable PROM (EPROM), a flash ROM, and a random access memory (RAM)). The program may be supplied to the computer through various types of transitory computer-readable media. Examples of the transitory computer-readable media include an electrical signal, an optical signal, and an electromagnetic wave. The transitory computer-readable media may supply the program to the computer through a wired communication channel such as an electric wire and an optical fiber, or through a wireless communication channel.

The storage 13 also functions as an air-flow rate waveform database (DB) 13A. For example, different production facilities are different from each other in operation start timing for starting operation, the length of an operation period from the operation start to the operation stop, and in time series variation of the compressed air-flow rate used during the operation period. However, in the case of the same production facility, the operation start timing may be random, but the length of the operation period from the operation start to the operation stop and the time series variation of the compressed air-flow rate used during the operation period may be the same. Accordingly, in the present embodiment, time series data representative of the time series variation of the compressed air-flow rate used in each of the production facilities during the operation period is stored in the air-flow rate waveform DB 13A for each of the plurality of production facilities. As described later, the processor 11 simulates time series variation of the total compressed air-flow rate used in the entire production line during simulation time (prescribed period) based on the time series data stored in the air-flow rate waveform DB 13A.

The input-output interface 14 is connected with component members such as a display device 141 and an input device 142. The display device 141 is configured to display screens such as a screen generated in the processor 11. Examples of the display device 141 include a display such as a liquid crystal display (LCD), and a cathode ray tube (CRT) display. The input device 142 is configured to receive operational input by a user. Examples of the input device 142 include a keyboard, a mouse, and a touch sensor. The display device 141 and the input device 142 may be integrated as a touch panel.

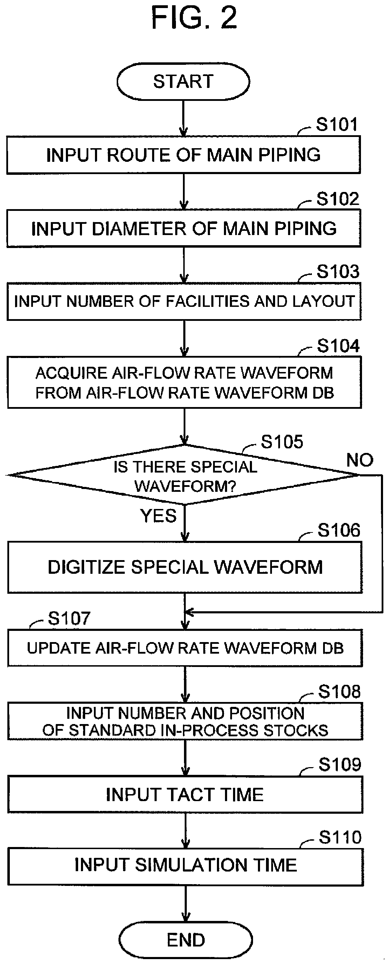

A description is now given of the calculation method for the compressed air-flow rate according to the present embodiment. First, an example of the flow of pre-processing will be described with reference to FIG. 2. The pre-processing is performed before simulating the time series variation of the total compressed air-flow rate used in the entire production line during simulation time (prescribed period), the entire production line having the plurality of production facilities that use compressed air.

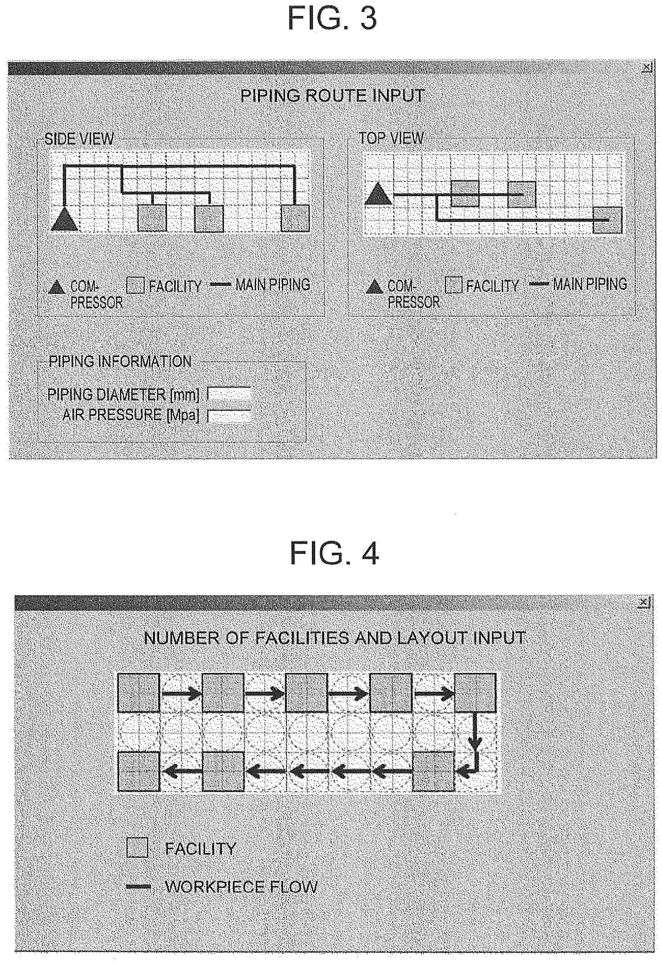

As illustrated in FIG. 2, the processor 11 receives through the input device 142 input of the route of main piping as main piping information (step S101). The main piping is the piping between a compressor that generates compressed air and each of the production facilities. The main piping does not include piping in each of the production facilities. Next, the processor 11 receives through the input device 142 input of a main piping diameter as the main pipeline information (step S102). For example, in steps S101, S102, the processor 11 displays an input screen illustrated in FIG. 3 on the display device 141. On the input screen, the processor 11 receives input of the main piping route and the piping diameter through the input device 142. The input screen illustrated in FIG. 3 is configured to receive not only the input of the main piping route and the piping diameter but also input of the pressure of the compressed air generated in the compressor.

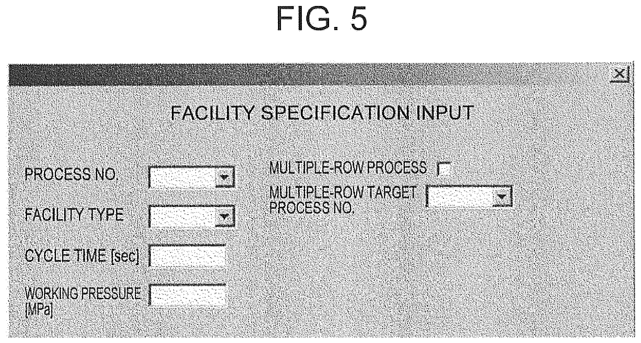

Next, the processor 11 receives input of the number of production facilities included in the production line and layout thereof through the input device 142 as facility information (step S103). For example, in step S103, the processor 11 first displays an input screen illustrated in FIG. 4 on the display device 141. On the input screen, the processor 11 receives input of the layout of the production facilities through the input device 142. Next, the processor 11 displays an input screen illustrated in FIG. 5 on the display device 141. On the input screen, the processor 11 receives input of the specification of each production facility through the input device 142. The input screen illustrated in FIG. 5 is configured to receive input of process No. representative of the order of the process executed by the production facility, the type of the production facility, a cycle time of the production facility, and the pressure used by the production facility. Among these parameters, the process No. can be used to determine an arrangement sequence of each production facility. The input screen illustrated in FIG. 5 is further configured to receive input of whether or not the production facility includes a multiple-row process composed of a plurality of processes arranged in parallel. When the production facility includes the multiple-row process, the input screen receives input of the multiple-row target process No. representative of the order of the multiple-row process.

Next, for each of the plurality of production facilities, the processor 11 acquires, from the air-flow rate waveform DB 13A in the storage 13, a waveform of the time series data on the compressed air-flow rate used in each of the production facilities during the operation period (step S104). For example, in the case of the production facilities such as a production facility for drilling holes and a production facility for pressing in pins, the waveforms of the time series data on the compressed air-flow rate used in these production facilities during the operation period become simple waveforms. Accordingly, for such production facilities, the digitized typical waveforms prestored in the air-flow rate waveform DB 13A are acquired.

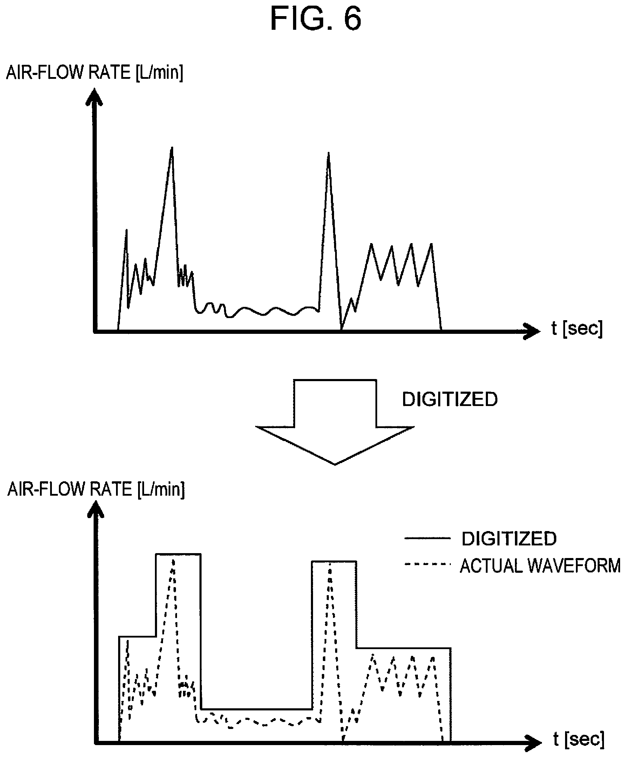

Next, the processor 11 determines whether or not the plurality of production facilities include a production facility whose waveform of the time series data on the compressed air-flow rate used during the operation period is a special waveform (step S105). The special waveform is different from typical waveforms prestored in the air-flow rate waveform DB 13A. For example, the special waveform is different from the typical waveforms in the timing of using the compressed air and in the flow rate. A specific example of the special waveform is illustrated in an upper graph of FIG. 6.

When the plurality of production facilities include a production facility whose waveform of the time series data on the compressed air-flow rate used during the operation period is a special waveform in step S105, (YES in step S105), the processor 11 digitizes and thereby simplifies the special waveform (step S106). The special waveform is digitized by, for example, a publicly known method involving sampling, quantization, and encoding of the waveform. For example, the waveform illustrated in the upper graph of FIG. 6 is digitized as illustrated in a lower graph of FIG. 6. The digitization of the special waveform in step S106 may be implemented not only by the processor 11 but also by manual entry performed by the user through the input device 142. When the plurality of production facilities include no production facility whose waveform of the time series data on the compressed air-flow rate used during the operation period is a special waveforms in step S105, (NO in step S105), all the waveforms can be acquired from the air-flow rate waveform DB 13A. Accordingly, step S106 is skipped, and the processing proceeds to step S107.

Next, for each of the plurality of production facilities, the processor 11 stores in the air-flow rate waveform DB 13A the digitized waveform of the time series data on the compressed air-flow rate used in each of the production facilities during the operation period. Accordingly, the air-flow rate waveform DB 13A is updated (step S107).

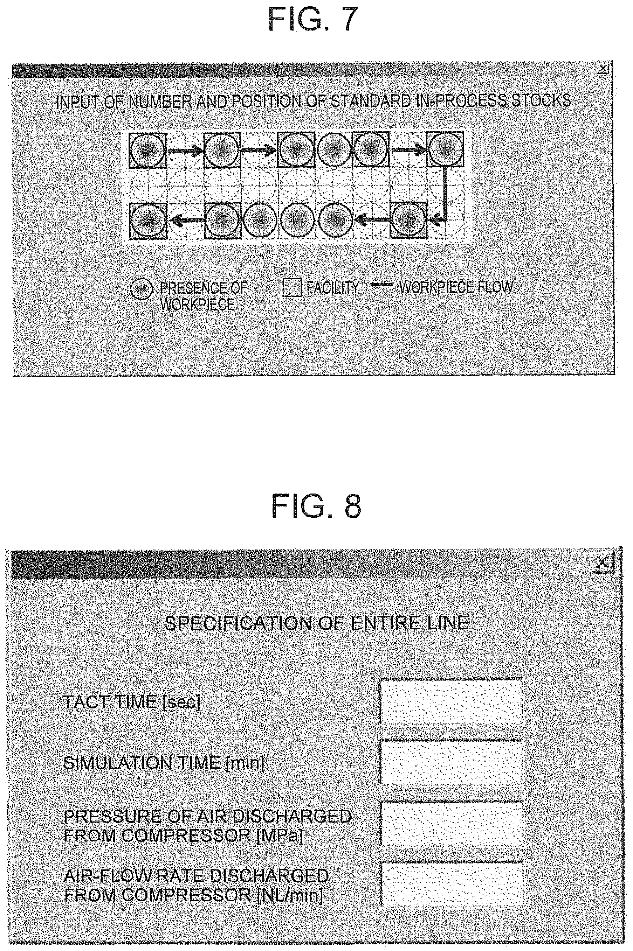

Next, the processor 11 receives through the input device 142 input of the number and the position of standard in-process stocks as the production auxiliary information (step S108). The standard in-process stocks are workpieces left as a buffer on the conveyor just behind unreliable production facilities (such as a facility frequently fails and stops). For example, in step S108, the processor 11 displays an input screen illustrated in FIG. 7 on the display device 141. On the input screen, the processor 11 receives input of the number and the position of the standard in-process stocks through the input device 142. In FIG. 7, the workpieces not positioned within the production facilities are workpieces left as a buffer on the conveyor.

Next, the processor 11 receives, through the input device 142, input of the tact time of the entire production line as the production auxiliary information (step S109). Next, the processor 11 receives, through the input device 142, input of simulation time representative of the length of a period in which simulation is executed (step S110). For example, in steps S109, S110, the processor 11 displays an input screen illustrated in FIG. 8 on the display device 141. On the input screen, the processor 11 receives input of the specification of the entire production line through the input device 142. The input screen illustrated in FIG. 8 is configured to receive not only the input of the tact time and the simulation time of the entire production line, but also input of the pressure of the compressed air generated in the compressor and the flow rate. At this point, the pre-processing performed before simulation is ended.

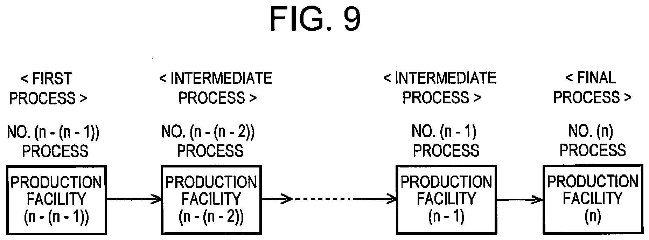

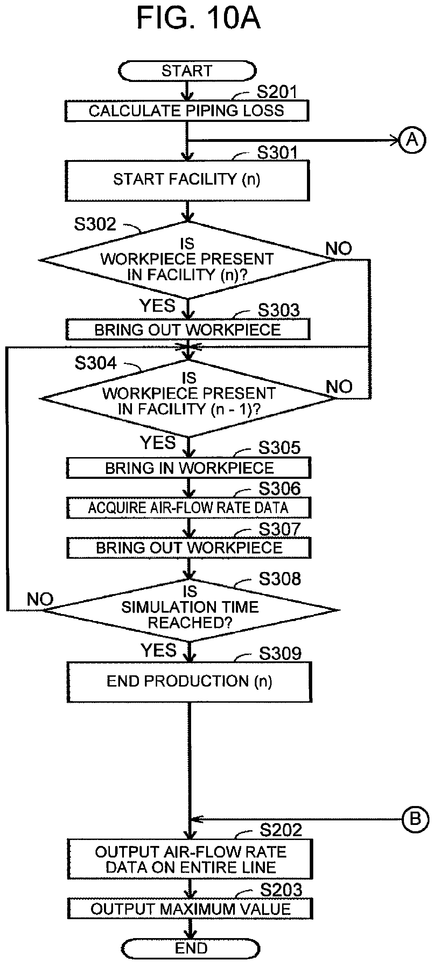

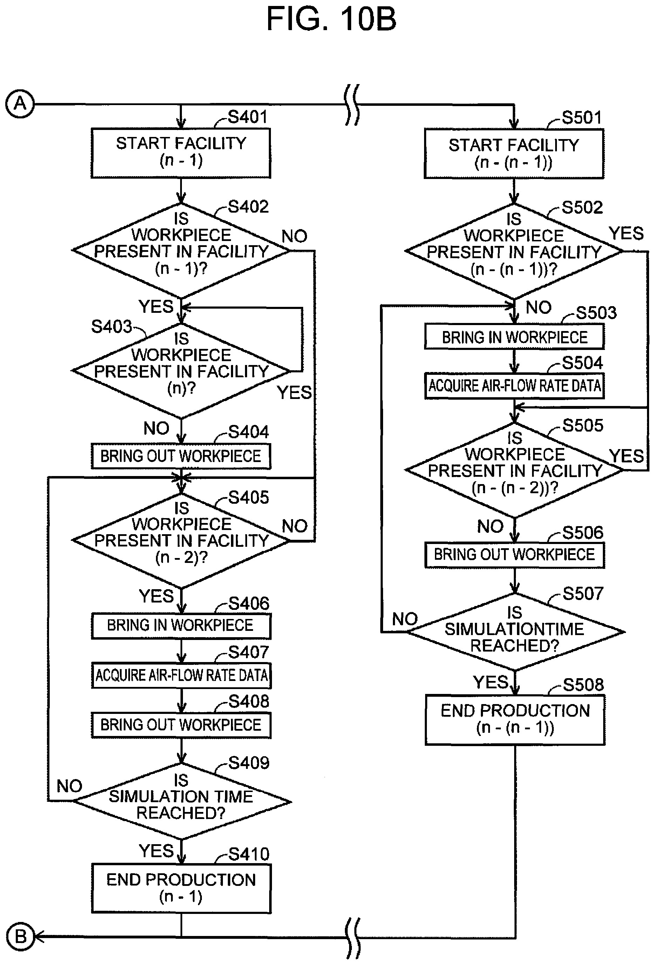

Next, an example of the flow of simulation processing of the time series variation of the total compressed air-flow rate will be described with reference to FIGS. 9 and 10, the total compressed air-flow rate being used during simulation time (prescribed period) in the entire production line having the plurality of production facilities that use compressed air.

Here, as illustrated in FIG. 9, the production line is composed of n (n is a natural number of 2 or larger) production facilities (n - (n - 1)) to (n) that use compressed air, the production facilities being arrayed in order with a production facility (n - (n - 1)) being the head. The production facilities (n - (n - 1)) to (n) execute No. (n - (n - 1)) process to No. (n) process, respectively. When the processing of FIGs. 10A and 10B is started, the production facilities are in a full workpiece state (the state where all the production facilities have workpieces) as in an actual production line.

As illustrated in FIGs. 10A and 10B, the processor 11 calculates, for each n production facilities (n - (n - 1)) to (n), a piping loss representative of the compressed air pressure lost inside the main piping between these production facilities and the compressor (step S201).

Next, the processor 11 starts generation of the time series data on the compressed air-flow rate used in n production facilities (n - (n - 1)) to (n) during the simulation time for each of the production facilities (steps S301, S401, S501).

Here, a description is first given of the generation of the time series data on the compressed air-flow rate in the production facility (n) that executes No. (n) process that is a final process. First, the processor 11 determines whether or not the production facility (n) has a workpiece (step S302). When the production facility (n) has the workpiece in step S302 (YES in step S302), the workpiece is brought out from the production facility (n) (step S303). When no workpiece is present in the production facility (n) (NO in step S302), it is not necessary to bring out any workpiece. Accordingly, step S303 is skipped, and the processing proceeds to step S304.

Next, the processor 11 determines whether or not the production facility (n - 1), which executes No. (n - 1) process that is the process previous to No. (n) process, has a workpiece (whether or not there is a workpiece which has already been brought out from the production facility (n - 1) but is not yet brought into the production facility (n) to be specific) (step S304). Specifically, the aforementioned workpiece is the workpiece which has already brought out from the production facility (n - 1) but is not yet brought into the production facility (n). When the production facility (n - 1) does not have a workpiece in step S304 (NO in step S304), no workpiece can be brought in. Accordingly, the processing returns to step S304.

When the production facility (n - 1) has a workpiece in step S304 (YES in step S304), the processor 11 brings the workpiece into the production facility (n) (step S305). That is, in the case of the production facility (n) that executes No. (n) process that is a final process, when no workpiece is present in the production facility (n), and the production facility (n - 1) that executes No. (n - 1) process, which is a process previous to No. (n) process, has a workpiece, the processor 11 brings the workpiece into the production facility (n). At this point, the processor 11 determines that the operation start timing for starting operation of the production facility (n) has come.

Here, a conveyor for conveying the workpiece is provided between the production facility (n) and the production facility (n - 1). The workpiece in the production facility (n - 1) is conveyed with the conveyer into the production facility (n). Accordingly, even when the production facility (n - 1) has a workpiece, the workpiece is not necessarily brought into the production facility (n) at once. In actuality, the workpiece is brought into the production facility (n) after the lapse of time taken for the conveyer to convey the workpiece lapses. However, in the present embodiment, when no workpiece is present in the production facility (n), and the production facility (n - 1) has a workpiece, the workpiece is assumed to be brought into the production facility (n) in disregard of the conveying time of the workpiece. When the workpiece is brought in, the operation start timing of the production facility (n) is determined to have come. The reason of the determination will be described below.

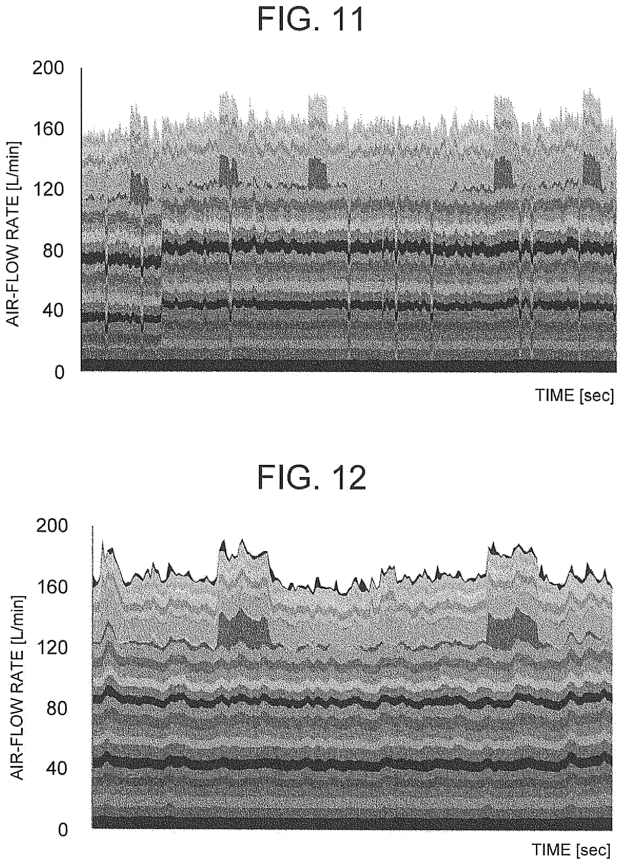

FIG. 11 illustrates waveforms of actual measurement values of the time series data on the total compressed air-flow rate in the case where the conveyor is present between the production facilities. FIG. 12 illustrates waveforms of the actual measurement values of the time series data on the total compressed air-flow rate in the case where no conveyor is present between the production facilities. FIGS. 11 and 12 illustrate the waveforms of the same production facilities. As illustrated in FIGS. 11 and 12, the presence of the conveyor between the production facilities does not cause a large change in the waveforms of the time series data on the total compressed air-flow rate. Difference between a maximum value of the total compressed air-flow rate without the conveyor and a maximum value of the total compressed air-flow rate with the conveyor is as small as about 2%. If, despite such a small difference, the program executed by the processor 11 is created such that the motion and conditions of the conveyor are programmed in accordance with an actual production line, the programs become complicated, which causes another problem that an enormous time is necessary to create the program. Accordingly, in the present embodiment, priority is given to simplifying the program, so that the time taken for the conveyer to convey the workpiece is disregarded.

When determining that the operation start timing of the production facility (n) has come, the processor 11 acquires from the air-flow rate waveform DB 13A the digitized waveform of the time series data on the compressed air-flow rate used in the production facility (n) during the operation period (step S306). Next, the processor 11 brings out the workpiece from the production facility (n) after the lapse of the operation period of the production facility (n) (step S307).

Next, the processor 11 determines whether or not the lapse of time after the start of generating the time series data on the compressed air-flow rate in the production facility (n) in step S301 reaches the simulation time (step S308). In step S308, when the lapsed time from step S301 does not reach the simulation time (NO in step S308), the processing returns to step S304. When the processing returns to step S304, no workpiece is present in the production facility (n). Accordingly, in step S304, when the production facility (n - 1) has a workpiece (YES in step S304), the processor 11 brings the workpiece into the production facility (n) (step S305). At that moment, the processor 11 determines that the operation start timing of the production facility (n) has come, and performs step S306 and onward.

That is, the processor 11 acquires from the air-flow rate waveform DB 13A the digitized waveform of the time series data on the compressed air-flow rate used in the production facility (n) during the operation period whenever determining that the operation start timing of the production facility (n) has come. Thus, the processor 11 generates the time series data on the compressed air-flow rate used in the production facility (n) during simulation time.

Meanwhile, when the lapsed time from step S301 reaches the simulation time in step S308 (YES in step S308), the processor 11 terminates generation of the time series data on the compressed air-flow rate in the production facility (n) (step S309).

Next, a description is given of the generation of the time series data on the compressed air-flow rate in the production facility (n - 1) that executes No. (n - 1) process that is an intermediate process. First, the processor 11 determines whether or not the production facility (n - 1) has a workpiece (step S402). In step S402, when the production facility (n - 1) has the workpiece (YES in step S402), the processor 11 then determines whether or not the production facility (n) that executes No. (n) process, which is a process subsequent to No. (n - 1) process, has a workpiece (step S403). In step S403, when no workpiece is present in the production facility (n) (NO in step S403), it indicates that the production facility (n - 1) has a workpiece and the production facility (n) has no workpiece. Accordingly, the processor 11 brings out the workpiece from the production facility (n - 1) (step S404). When there is no workpiece in the production facility (n - 1) (NO in step S402), it is not necessary to bring out any workpiece. Accordingly, steps S403, S404 are skipped, and the processing proceeds to step S405. When the production facility (n) has a workpiece in step S403 (YES in step S403), the workpiece of the production facility (n - 1) cannot be brought out. Accordingly, the processing returns to step S403. That is, the workpiece in the production facility (n - 1) is brought out after the workpiece is no longer present in the production facility (n).

Next, the processor 11 determines whether or not the production facility (n - 2), which executes No. (n - 2) process that is the process previous to No. (n - 1) process, has a workpiece (whether or not there is a workpiece which has already been carried out from the production facility (n - 2) but is not yet carried into the production facility (n - 1) to be specific) (step S405). When the production facility (n - 2) does not have any workpiece in step S405 (NO in step S405), no workpiece can be brought in. Accordingly, the processing returns to step S405.

When the production facility (n - 2) has a workpiece in step S405 (YES in step S405), the processor 11 brings the workpiece into the production facility (n - 1) (step S406). That is, in the case of the production facility (n - 1) that executes No. (n - 1) process that is the intermediate process, when no workpiece is present in the production facility (n-1), and the production facility (n - 2) that executes No. (n - 2) process, which is a process previous to No. (n - 1) process, has a workpiece, the processor 11 brings the workpiece into the production facility (n-1). At that point, the processor 11 determines that the operation start timing for starting operation of the production facility (n - 1) has come. At this time, the conveying time of the workpiece by the conveyor between the production facility (n - 1) and the production facility (n - 2) is disregarded as in the case of the production facility (n).

When determining that the operation start timing of the production facility (n - 1) has come, the processor 11 acquires from the air-flow rate waveform DB 13A the digitized waveform of the time series data on the compressed air-flow rate used in the production facility (n - 1) during the operation period (step S407). Next, the processor 11 brings out the workpiece from the production facility (n - 1) after the lapse of the operation period of the production facility (n - 1) (step S408).

Next, the processor 11 determines whether or not the lapse of time after the start of generating the time series data on the compressed air-flow rate in the production facility (n - 1) in step S401 reaches the simulation time (step S409). In step S409, when the lapsed time from step S401 does not reach the simulation time (NO in step S409), the processing returns to step S405. When the processing returns to step S405, no workpiece is present in the production facility (n - 1). Accordingly, in step S405, when the production facility (n - 2) has a workpiece (YES in step S405), the processor 11 brings the workpiece into the production facility (n - 1) (step S406). At that moment, the processor 11 determines that the operation start timing of the production facility (n - 1) has come, and performs step S407 and onward.

That is, the processor 11 acquires from the air-flow rate waveform DB 13A the digitized waveform of the time series data on the compressed air-flow rate used in the production facility (n - 1) during the operation period whenever it is determined that the operation start timing of the production facility (n - 1) has come. Thus, the processor 11 generates the time series data on the compressed air-flow rate used in the production facility (n - 1) during the simulation time.

Meanwhile, when the lapsed time from step S401 reaches the simulation time in step S409 (YES in step S409), the processor 11 terminates generation of the time series data on the compressed air-flow rate in the production facility (n - 1) (step S410).

The time series data on the compressed air-flow rate in the production facilities (n- (n - 2)) to (n - 2), which execute No. (n- (n - 2)) process to (n - 2) process that are the intermediate processes, respectively, may be generated substantially in the same manner as the time series data on the compressed air-flow rate in the production facility (n - 1). Accordingly, a description of the generation method thereof is omitted.

Next, a description is given of the generation of the time series data on the compressed air-flow rate in the production facility (n - (n - 1)) that executes No. (n - (n - 1)) process that is a first process. First, the processor 11 determines whether or not the production facility (n - (n - 1)) has a workpiece (step S502). When a workpiece is present in the production facility (n - (n - 1)) (YES in step S502), it is not necessary to bring in the workpiece. Accordingly, later-described steps S503, S504 are skipped, and the processing proceeds to step S505.

When the production facility (n - (n - 1)) does not have any workpiece in step S502 (NO in step S502), the processor 11 brings the workpiece into the production facility (n - (n - 1)) (step S503). That is, in the case of the production facility (n - (n - 1)) that executes No. (n - (n - 1)) process that is the first process, the processor 11 brings a workpiece into the production facility (n - (n - 1)) when no workpiece is present in the production facility (n - (n - 1)). At that time, the processor 11 determines that the operation start timing for starting operation of the production facility (n - (n - 1)) has come. At this time, the conveying time of the workpiece by the conveyor present immediately before the production facility (n - (n - 1)) is disregarded as in the case of the production facility (n).

When determining that the operation start timing of the production facility (n - (n - 1)) has come, the processor 11 acquires from the air-flow rate waveform DB 13A the digitized waveform of the time series data on the compressed air-flow rate used in the production facility (n- (n - 1)) during the operation period (step S504).

Next, the processor 11 determines whether or not a workpiece is present in the production facility (n- (n - 2)), which executes No. (n- (n - 2)) process that is a process subsequent to No. (n - (n - 1)) process, after the lapse of the operation period of the production facility (n - (n - 1)) (step S505). When the production facility (n-(n - 2)) does not have any workpiece in step S505 (NO in step S505), a workpiece is brought out from the production facility (n - (n - 1)) (step S506). When the production facility (n-(n - 2)) has a workpiece in step S505 (YES in step S505), the workpiece of the production facility (n - (n - 1)) cannot be brought out. Accordingly, the processing returns to step S505. That is, the workpiece in the production facility (n - (n - 1)) is brought out after the workpiece is no longer present in the production facility (n-(n - 2)).

Next, the processor 11 determines whether or not the lapse of time after the start of generating the time series data on the compressed air-flow rate in the production facility (n - (n - 1)) in step S501 reaches simulation time (step S507). In step S507, when the lapsed time from step S501 does not reach the simulation time (NO in step S507), the processing returns to step S503. When the processing returns to step S503, no workpiece is present in the production facility (n - (n - 1)). Accordingly, when the processing returns to step S503, the processor 11 brings a workpiece into the production facility (n - (n - 1)) (step S503). At that moment, the processor 11 determines that the operation start timing of the production facility (n - (n - 1)) has come, and performs step S504 and onward.

That is, the processor 11 acquires from the air-flow rate waveform DB 13A the digitized waveform of the time series data on the compressed air-flow rate used in the production facility (n - (n - 1)) during the operation period whenever it is determined that the operation start timing of the production facility (n - (n - 1)) has come. Thus, the processor 11 generates the time series data on the compressed air-flow rate used in the production facility (n - (n - 1)) during the simulation time.

Meanwhile, when the lapsed time from step S501 reaches the simulation time in step S507 (YES in step S507), the processor 11 terminates generation of the time series data on the compressed air-flow rate in the production facility (n - (n - 1)) (step S508).

The above-described processing generates the time series data on the compressed air-flow rate for each of the production facilities (n - (n - 1)) to (n), the compressed air-flow rate being used in each of the production facilities during the simulation time. Next, the processor 11 calculates time series data representative of time series variation of the total compressed air-flow rate used in the entire production line during simulation by integrating the time series data on the compressed air-flow rate used during the simulation time, the time series data being generated for each of n production facilities (n - (n - 1)) to (n). The processor 11 then outputs the calculated time series data (step S202). At this time, the processor 11 displays and outputs a screen displaying the calculated time series data on the display device 141, for example.

Then, the processor 11 outputs a maximum value in the total compressed air-flow rate during the simulation time (step S203). At this time, the processor 11 displays and outputs the screen representative of the maximum value in the total compressed air-flow rate on the display device 141, for example.

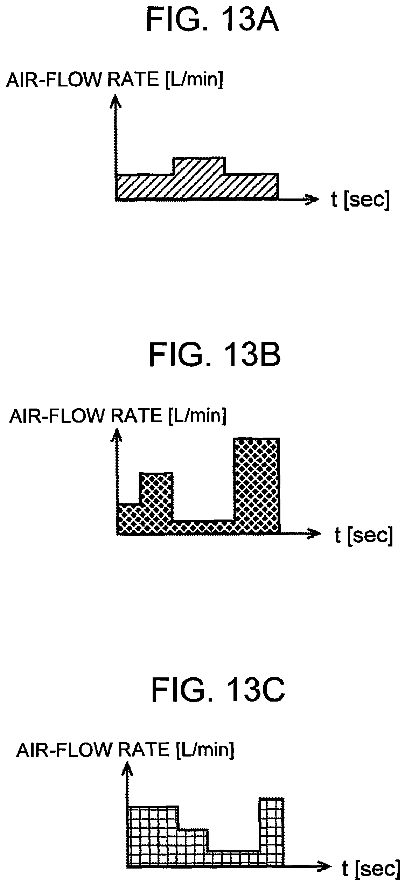

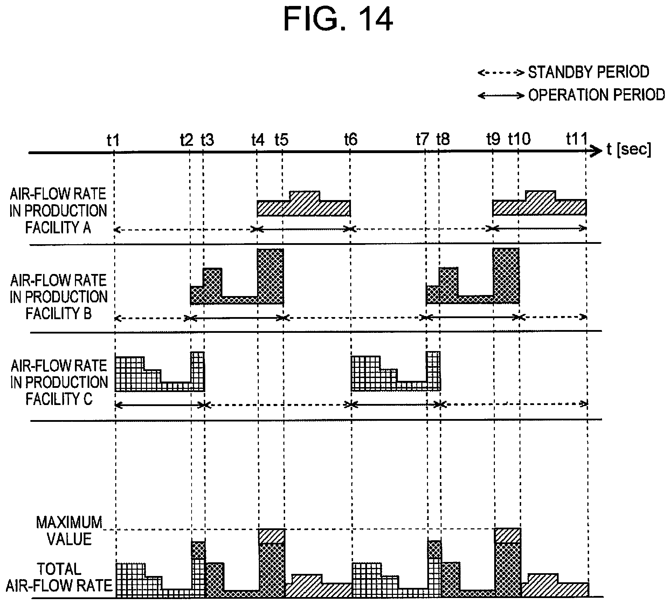

Next, the compressed air-flow rate calculation method according to the present embodiment will be described based on a specific example with reference to FIGS. 13A to 13C and FIG. 14. Here, the production line is configured such that three production facilities A to C that use compressed air are arrayed in order with the production facility A at the head.

First, in the pre-processing performed before the simulation, for each of the three production facilities A to C, the processor 11 stores in the air-flow rate waveform DB 13A the digitized waveform of the time series data on the compressed air-flow rate used in each of the production facilities during the operation period. Here, assume that the waveforms as illustrated in FIGS. 13A to 13C are stored for the three production facilities A to C, respectively.

Next, the processor 11 starts simulation processing. In the processing, the processor 11 starts generation of the time series data on the compressed air-flow rate for each of the production facilities, the compressed air-flow rate being used in each of the three production facilities A to C during the simulation time. Here, as illustrated in FIG. 14, the simulation time is a period from time t1 to t11.

First, in the case of the production facility A, the processor 11 determines that the operation start timing has come at time t4 and t9 during the simulation time. Accordingly, the processor 11 acquires from the air-flow rate waveform DB 13A the digitized waveform of the time series data on the compressed air-flow rate used in the production facility A during the operation period.

In the case of the production facility B, the processor 11 determines that the operation start timing has come at time t2 and t7 during the simulation time. Accordingly, the processor 11 acquires from the air-flow rate waveform DB 13A the digitized waveform of the time series data on the compressed air-flow rate used in the production facility B during the operation period at time t2 and t7.

In the case of the production facility C, the processor 11 determines that the operation start timing has come at time t1 and t6 during the simulation time. Accordingly, the processor 11 acquires from the air-flow rate waveform DB 13A the digitized waveform of the time series data on the compressed air-flow rate used in the production facility C during the operation period at time t1 and t6.

The above-described processing generates the time series data on the compressed air-flow rate for each of the production facilities, the compressed air-flow rate being used in each of the three production facilities during the simulation time. Next, the processor 11 calculates the time series data on the total compressed air-flow rate used in the entire production line during the simulation time by integrating the time series data on the compressed air-flow rate used during the simulation time, the time series data being generated for each of the three production facilities A to C. The processor 11 then outputs the calculated time series data.

At this time, in the time series data on the total compressed air-flow rate, the total compressed air-flow rate between time t4 and t5 and between time t9 and t10 marks a maximum value. Accordingly, the processor 11 outputs the total compressed air-flow rate between time t4 and t5 and between time t9 and t10 as the maximum value in the total compressed air-flow rate.

As described in the foregoing, according to the present embodiment, the air-flow rate waveform DB 13A prestores, for each of the plurality of production facilities, the time series data on the compressed air-flow rate in each of the production facilities during the operation period from the start of operation to the stop of the operation. The processor 11 acquires for each of the plurality of production facilities the time series data on the compressed air-flow rate in each of the production facilities during the operation period from the air-flow rate waveform DB 13A, whenever the operation start timing has come in each of the production facilities during a prescribed period for performing simulation. Thus, the processor 11 generates the time series data on the compressed air-flow rate in each of the plurality of production facilities during the prescribed period. The processor 11 then calculates the time series data on the total compressed air-flow rate in the entire production line during the prescribed period by integrating the time series data on the compressed air-flow rate in each of plurality of production facilities during the prescribed period.

Accordingly, even when a plurality of production facilities are each different in the operation start and operation stop timing in a production line having the plurality of production facilities that use compressed air, the time series data on the compressed air-flow rate in each of the plurality of production facilities can accurately be generated. As a result, the total compressed air-flow rate in the entire production line can also be calculated with sufficient accuracy.

As a result, a compressor having a proper output volume corresponding to the total compressed air-flow rate can be selected. For example, in the example of FIG. 14, a compressor to be selected may have a output volume specification in proportion to the total compressed air-flow rate in a period between time t4 and t5 and in a period between time t9 and t10. Since the compressor of the proper output volume can be selected in this way, it becomes possible to eliminate the necessity of adjusting the operation start and operation stop timing of any one of the production facilities as disclosed in JP 2010-128625 A. As a result, finished products can be produced as scheduled. Furthermore, since the compressor of the proper output volume can be selected, the compressor having excessive performance can be avoided, which is advantageous in terms of the investment, the running cost, and the energy saving.

According to the present embodiment, the digitized waveform is stored in the air-flow rate waveform DB 13A as a waveform of the time series data on the compressed air-flow rate in each of plurality of production facilities during the operation period. Thus, the waveform of the time series data on the compressed air-flow rate is digitized and thereby simplified, which results in simplification of the program executed by the processor 11 so as to implement the compressed air-flow rate calculation method according to the present embodiment. Therefore, the time taken for creating the program can be reduced.

According to the present embodiment, when no workpiece is present in a production facility that executes the first process, the processor 11 brings a workpiece into the production facility, and at that moment, the processor 11 determines that the operation start timing of the production facility has come. When no workpiece is present in one of the production facilities, which are other than the production facility that executes the first process, and a workpiece is present in a production facility that executes a process previous to the process executed by the one of the production facilities, the processor 11 brings the workpiece into the one of the production facilities. At that moment, the processor 11 determines that the operation start timing of the one of the production facilities has come. That is, the processor 11 brings a workpiece into the production facility in disregard of the conveying time by the conveyor, and at that time, the processor 11 determines that the operation start timing of the production facility has come. When the conveying time by the conveyor is disregarded in this way, the aforementioned program is further simplified, which further reduces the time taken for creating the program.

The present invention is not limited to the embodiments disclosed above, and appropriate modifications are possible without departing from the scope of the present invention.

## Claims

1. A compressed air-flow rate calculation method for calculating a total compressed air-flow rate used in an entire production line having a plurality of production facilities that use compressed air, the method comprising:
inputting facility information including the number of the plurality of production facilities and layout information, and production supplementary information including information on tact time of the entire production line;
storing, in a storage device, time series data representative of time series variation of a compressed air-flow rate for each of the plurality of production facilities, the compressed air-flow rate being used in each of the production facilities during an operation period from an operation start to an operation stop; and
simulating time series variation of the total compressed air-flow rate used in the entire production line during a prescribed period, wherein
the simulation includes
determining, for each of the plurality of production facilities, whether or not operation start timing has come in each of the production facilities during the prescribed period,
generating, for each of the plurality of production facilities, time series data on the compressed air-flow rate used in each of the production facilities during the prescribed period by acquiring, from the storage device, the time series data on the compressed air-flow rate used in each of the production facilities during the operation period, whenever the operation start timing is determined to have come in each of the production facilities, and
calculating time series data representative of the time series variation of the total compressed air-flow rate used in the entire production line during the prescribed period by integrating the time series data on the compressed air-flow rate used during the prescribed period, the time series data being generated for each of the plurality of production facilities.

2. The compressed air-flow rate calculation method according to claim 1, wherein a waveform that is digitized time series data on the compressed air-flow rate used in each of the plurality of production facilities during the operation period is stored in the storage device for each of the production facilities.

3. The compressed air-flow rate calculation method according to claim 1 or 2, wherein
in a case where a process executed by one of the production facilities is a first process, and no workpiece is present in the production facility, the operation start timing is determined to have come in the production facility when the workpiece is brought into the production facility, whereas
in a case where the process executed by one of the production facilities is not the first process, no workpiece is present in the production facility, and a workpiece is present in a production facility that executes a process previous to the process executed by the one of the production facilities, the operation start timing is determined to have come in the one of the production facilities when the workpiece is brought into the one of the production facilities.

4. A compressed air-flow rate calculation device for calculating a total compressed air-flow rate used in an entire production line having a plurality of production facilities that use compressed air, the calculation device comprising:
an input device (142) configured to receive input of facility information including the number of the plurality of production facilities and layout information thereon, and production supplementary information including information on tact time of the entire production line;
a storage device (13) configured to store time series data representative of time series variation of a compressed air-flow rate for each of the plurality of production facilities, the compressed air-flow rate being used in each of the production facilities during an operation period from an operation start to an operation stop; and
a processor (11) configured to simulate time series variation of the total compressed air-flow rate used in the entire production line during a prescribed period, wherein
the processor (11) is configured to
determine, for each of the plurality of production facilities, whether or not operation start timing has come in each of the production facilities during the prescribed period that is during the simulation,
generate, for each of the plurality of production facilities, time series data on the compressed air-flow rate used in each of the production facilities during the prescribed period by acquiring, from the storage device, the time series data on the compressed air-flow rate used in each of the production facilities during the operation period, whenever the operation start timing is determined to have come in each of the production facilities, and
calculate time series data representative of the time series variation of the total compressed air-flow rate used in the entire production line during the prescribed period by integrating the time series data on the compressed air-flow rate used during the prescribed period, the time series data being generated for each of the plurality of production facilities.

5. A computer-readable storage medium, the storage medium being configured to store a computer program and cause a computer to execute steps upon execution of the computer program, the steps comprising:
input steps (S103, S109) of inputting, in the computer configured to calculate a total compressed air-flow rate used in an entire production line having a plurality of production facilities that use compressed air, facility information including the number of the plurality of production facilities and layout information, and production supplementary information including information on tact time of the entire production line;
a storage step (S107) of storing, in a storage device, time series data representative of time series variation of a compressed air-flow rate for each of the plurality of production facilities, the compressed air-flow rate being used in each of the production facilities during an operation period from an operation start to an operation stop; and
a simulation step of simulating time series variation of the total compressed air-flow rate used in the entire production line during a prescribed period, wherein
the simulation step includes
a determination step of determining, for each of the plurality of production facilities, whether or not operation start timing has come in each of the production facilities during the prescribed period,
a generation step of generating, for each of the plurality of production facilities, time series data on the compressed air-flow rate used in each of the production facilities during the prescribed period by acquiring, from the storage device, the time series data on the compressed air-flow rate used in each of the production facilities during the operation period, whenever the operation start timing is determined to have come in each of the production facilities, and
a calculation step of calculating time series data representative of the time series variation of the total compressed air-flow rate used in the entire production line during the prescribed period by integrating the time series data on the compressed air-flow rate used during the prescribed period, the time series data being generated for each of the plurality of production facilities.
